# FASCICULE DE BREVET EUROPEEN

(11) **EP 0 629 108 B1**
(45) Date de publication et mention de la délivrance du brevet: **21.08.1996**
(21) Numéro de dépôt: 94401198.0
(22) Date de dépôt: 31.05.1994
(51) Int. Cl.: H05K 1/14

(54) **Bus-barre de distribution d'alimentation pour support de composants, ce support de composants et barrettes de distribution pour relier le bus-barre et le support**
Versorgungsverteilung-Busschiene für Komponentenunterlage, die Komponentenunterlage und Verteilungsbrücken zum Verbinden der Busschiene mit der Unterlage
Supply distribution bus bar for component support, the component support and distribution strips for joining the busbar with the support

(30) Priorité: 09.06.1993 FR 9306908
(43) Date de publication de la demande: 14.12.1994
(73) Titulaire: SOCIETE D'APPLICATIONS GENERALES D'ELECTRICITE ET DE MECANIQUE SAGEM, F-75783 Paris Cédex 16 (FR)
(72) Inventeur: Panhaleux, Patrick, F-95800 Courdimanche (FR)
(74) Mandataire: Bloch, Gérard

(56) Documents cités:
- DE-U- 8 813 684
- US-A- 4 394 532
- IBM TECHNICAL DISCLOSURE BULLETIN, vol.24, no.2, Juillet 1981 pages 1239 - 1240

## Description

Un bus-barre de distribution d'alimentation sert à alimenter, depuis un connecteur d'alimentation, les divers composants électriques d'une carte de circuit imprimé, lorsque ces composants ont une consommation élevée.

En effet, bien que la carte comporte des pistes conductrices, celles-ci ne présentent pas une section suffisante pour transmettre, sans chute de tension excessive, le courant nécessaire aux composants éloignés du connecteur. Il faut donc rapporter sur la carte un bus-barre, qui présente une section suffisamment élevée et qui, à la manière d'un peigne, comporte des broches de distribution d'alimentation qui sont soudées chacune à une piste de la carte alimentant un nombre limité de composants voisins. La tension d'alimentation, qui doit rester dans des limites relativement étroites pour que le fonctionnement correct des composants soit assuré, est ainsi partout disponible sans dégradation.

Pour assurer une telle distribution de courant électrique, il est aussi connu de prévoir des fils de forte section terminés par des cosses reliées à des bornes de la carte. Cela nécessite cependant beaucoup d'opérations manuelles pour monter les bornes et préparer les fils avec les cosses, ce qui est d'un coût élevé. En outre, les fils risquent d'être arrachés.

Il existe aussi des barres de cuivre qui, lorsqu'il faut distribuer plusieurs tensions, sont assemblées côte à côte par un film isolant et percées pour recevoir des boulons de raccordement de chaque barre à la carte. Ces barres présentent l'inconvénient de nécessiter un usinage spécifique et un montage avec un film isolant, tandis que leur raccordement nécessite encore une opération manuelle.

US-A-4 394 532 décrit un bus-barre plan miniaturisé en forme de condensateur comprenant des barrettes de distribution d'alimentation reliées aux couches conductrices formées aux surfaces opposées d'une lame isolante.

On peut aussi prévoir d'utiliser, pour distribuer plusieurs alimentations, des lames isolées noyées dans une résine, mais le coût de la résine et celui du montage ne sont pas négligeables. De plus, l'adaptation de la forme d'un tel bus-barre plan à chaque problème de distribution est coûteuse puisqu'il faut à chaque fois prévoir une découpe spécifique pour les lames.

La présente invention vise à pallier ces inconvénients.

A cet effet, elle concerne un bus-barre plan de distribution d'alimentation électrique, caractérisé par le fait qu'il comporte un circuit imprimé sur une carte.

On utilise ainsi une technologie dont toutes les étapes de fabrication sont automatisées, donc peu coûteuses.

Avantageusement, le circuit imprimé est un circuit multicouche.

L'invention concerne également un support de composants électriques, sur lequel est monté le bus-barre pour alimenter les composants par l'intermédiaire de barrettes de distribution d'alimentation reliées au support et au bus-barre.

L'invention concerne enfin une barrette de distribution d'alimentation pour relier le support de composants au bus-barre, caractérisée par le fait qu'elle comporte deux bords différents de liaison au support et au bus-barre.

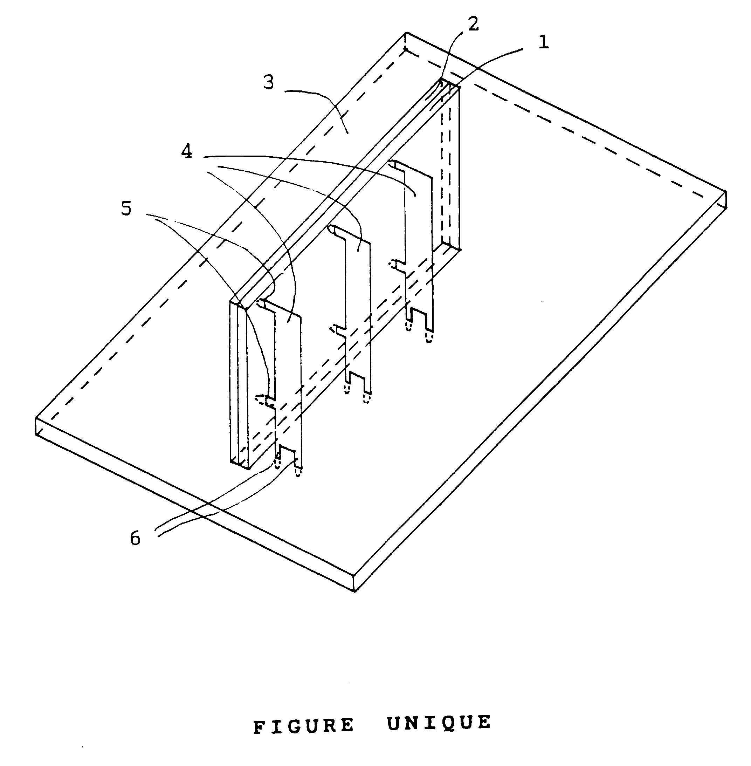

L'invention sera mieux comprise à l'aide de la description suivante de la forme de réalisation préférée du bus-barre de l'invention, qui est représenté en perspective sur la figure unique du dessin annexé.

Le bus-barre comporte une couche de cuivre 1 appartenant à une carte à circuit imprimé de forme allongée dont une couche isolante 2 porte la couche 1. Le bus-barre sert à distribuer un courant d'alimentation sur un support de composants électriques 3 qui le porte. Des barrettes métalliques 4, ici au nombre de trois, sont régulièrement espacées le long du bus-barre et assurent sa fixation sur le support 3 ainsi que la distribution du courant, provenant d'un connecteur non représenté du support 3 et relié à l'une des barrettes 4 par une liaison courte de forte section.

Les barrettes 4 sont ici aplaties et disposées dans un plan perpendiculaire au plan de la carte 1-2 et à celui du support 3.

Elles présentent ici deux ergots de soudage 5, sur un de leurs bords, qui traversent la couche 1 et y sont soudés. Deux autres ergots 6, ici sur un bord perpendiculaire au premier, sont de la même façon soudés à des pistes de distribution d'alimentation (non représentées) du support 3.

Dans le présent exemple, la couche de cuivre a une épaisseur de 200 microns environ, ce qui offre une section élevée pour le passage du courant à distribuer, en conservant une largeur modérée (hauteur sur la figure) au bus-barre.

En cas de besoin, on peut utiliser une carte de circuit imprimé multicouche et relier en parallèle, par des trous métallisés ou des fils de traversée, plusieurs des couches pour accroître la section du bus-barre.

On peut aussi distribuer plusieurs courants isolés traversant chacun une ou quelques couches de cuivre.

Avantageusement, on recouvre la ou les couches externes d'une couche à base d'étain pour augmenter encore la section tout en protégeant le cuivre contre l'oxydation.

## Revendications

1. Bus-barre plan de distribution d'alimentation électrique, caractérisé par le fait qu'il comporte un circuit imprimé (1) sur une carte (1, 2).

2. Bus-barre selon la revendication 1, dans lequel le circuit imprimé (1, 2) est un circuit multicouche.

3. Bus-barre selon la revendication 2, dans lequel le circuit multicouche (1, 2) est agencé pour distribuer plusieurs alimentations.

4. Support de composants électriques (3) sur lequel est monté le bus-barre (1, 2) selon l'une des revendications 1 à 3, pour alimenter des composants par l'intermédiaire de barrettes de distribution d'alimentation (4) reliées au support (3) et au bus-barre (1-2).

5. Barrette de distribution d'alimentation (4) pour relier le support de composants (3) de la revendication 4 au bus-barre (1,2) de l'une des revendications 1 à 3, caractérisée par le fait qu'elle comporte deux bords différents (5, 6) de liaison au support (3) et au bus-barre (1,2).

6. Barrette selon la revendication 5, dans laquelle les deux bords de liaison (5, 6) sont perpendiculaires entre eux.

## Patentansprüche

1. Ebener elektrischer Versorgungs-Busverteiler, dadurch gekennzeichnet, daß er eine gedruckte Schaltung auf einer Karte (1, 2) aufweist.

2. Busverteiler nach Anspruch 1, bei dem die gedruckte Schaltung (1, 2) eine Mehrschichtschaltung ist.

3. Busverteiler nach Anspruch 2, bei dem die Mehrschichtschaltung (1, 2) für die Verteilung mehrerer Versorgungen vorgesehen ist.

4. Träger elektrischer Bauteile (3), auf dem der Busverteiler (1, 2) gemäß einem der Ansprüche 1 bis 3 angeordnet ist, zur Versorgung von Bauteilen über Verteilungs-Versorgungsstege (4), die mit dem Träger (3) und dem Busverteiler (1-2) verbunden sind.

5. Verteilungs-Versorgungssteg (4) für die Verbindung des Trägers (3) nach Anspruch 4 von Bauteilen mit dem Busverteiler (1, 2) aus einem der Ansprüche 1 bis 3, dadurch gekennzeichnet, daß er zwei unterschiedliche Ränder (5, 6) für den Anschluß an den Träger (3) und den Busverteiler (1, 2) aufweist.

6. Steg nach Anspruch 5, bei dem die beiden Anschlußränder (5, 6) zueinander lotrecht sind.

## Claims

1. Flat bus-bar for electrical power distribution, characterised by the fact that it comprises a printed circuit (1) on a board (1, 2).

2. Bus-bar according to Claim 1, in which the printed circuit (1, 2) is a multi-layer circuit.

3. Bus-bar according to Claim 2, in which the multi-layer circuit (1, 2) is arranged to distribute several supplies.

4. Support for electrical components (3) on which is mounted the bus-bar (1, 2) according to one of Claims 1 to 3, for supplying components through the intermediary of power supply distribution strips (4) connected to the support (3) and to the bus-bar (1, 2).

5. Power supply distribution strip (4) for connecting the component support (3) of Claim 4 to the bus-bar (1, 2) of one of Claims 1 to 3, characterised by the fact that it comprises two different edges (5, 6) for connection to the support (3) and to the bus-bar (1, 2).

6. Strip according to Claim 5, in which the two connecting edges (5, 6) are perpendicular to each other.
